# EUROPEAN PATENT SPECIFICATION

(11) **EP 2 445 326 B1**
(45) Date of publication and mention of the grant of the patent: **05.11.2014**
(21) Application number: 11186353.6
(22) Date of filing: 24.10.2011
(51) Int. Cl.: H05K 5/02, H01R 13/60, B43K 23/12, B43K 24/06

(54) **Pen with data storage device**
Stift mit Datenspeichervorrichtung
Stylo avec dispositif de stockage de données

(30) Priority: 25.10.2010 GB 201017982
(43) Date of publication of application: 25.04.2012
(73) Proprietor: Flashbay Limited, London SW6 2TW (GB)
(72) Inventor: Schlossstein, Karl-Phillip, London SW6 2TW (GB); Roberts, James, London SW18 2HN (GB); Billington, Charlie, London SW6 2AL (GB)
(74) Representative: Beck Greener

(56) References cited:
- DE-U1-202004 008 168
- US-A1- 2005 009 388
- US-A1- 2005 083 315
- US-A1- 2009 004 898
- US-A1- 2009 112 067
- US-B1- 7 401 992

## Description

The present invention relates to a pen and in particular a pen having a data storage device.

It is known to provide a pen with a data storage device such as a removable flash drive. The flash drive is usually connected to the body of the pen at the USB interface end using either a screw fitting or a friction fit. Both of these connection means have disadvantages. In addition, the flash drive forms part of the body of the pen, with the pen's pocket clip being attached to the USB interface. US6,905,352 discloses such a pen.

Document US 2005/0083315 discloses a device according to the preamble of claim 1.

The prior art flash drive-containing pens having a screw fitting require the screw fitting to have a diameter greater than the size of the USB interface. This typically results in a large and bulky pen, which is not satisfactory. Both the screw fitting and the friction fit fastening require coordination to separate the two parts of the pen or put them back together. This will typically require the use of two hands. It would be preferable to provide a pen with a flash drive in which the flash drive can be easily removed from the pen without the need to remove the pen from a pocket. Likewise, it would be desirable to allow the USB interface of the flash drive to be easily repositioned in the pen.

According to a first aspect of the present invention, there is provided a writing implement comprising:
a body portion having a writing tip; and
a removable portion comprising a data storage device having a data transfer interface, wherein the data transfer interface comprises a ferromagnetic material. wherein the body portion comprises a receiving portion for receiving the data transfer interface, and wherein the receiving portion comprises a magnet such that the magnet releasably connects the receiving portion to the data storage device.

The present invention advantageously allows the easy removal of the data storage device. The magnet also helps guide the data transfer interface into the receiving portion, making replacement of the storage device straightforward.

It is preferred that the storage device is a flash drive.

The data transfer interface is any interface which contains a ferromagnetic material and therefore interacts with the magnet. Typically, the ferromagnetic material will be a metallic element or alloy such as iron. Other ferromagnetic materials are known however. One standard interface currently in use is a USB interface. An interface of this kind is suitable for the present invention. However, other interfaces are also within the scope of the present invention.

In a preferred embodiment of the present invention, the body portion additionally comprises a pocket clip. The attachment of the pocket clip to the body portion permits the flash drive to be removed from the writing implement without the need to remove the implement from a pocket.

In a preferred embodiment, the connection means is provided by a permanent magnet in the cover. An attractive force exists between the magnet and the metallic USB interface such that the flash drive is held in position in the cover. The size, shape and strength of the magnet can be adjusted to select the required strength for providing a suitable connection so that the flash drive cannot be too easily separated from the body of the pen, but at the same time can be removed using one hand.

The magnet is preferably a rare earth magnet, and more preferably a neodymium magnet. The shape of the USB interface means that it does not overlap with the entire surface area of one side of a magnet. Therefore, in order to provide sufficient restraining force, it is necessary to use a magnet of greater magnetic field strength than if there was complete overlap between the USB interface and the magnet. The skilled person will be able to select a magnet which will provide the required restraining force to the USB interface. By way of example, a neodymium N45 magnet of dimensions 5x15x3 mm and a strength of 3920 Gauss is appropriate to hold the USB interface in place. Other sizes, shapes and strengths of magnet will also be appropriate, depending on the amount of overlap with the USB interface.

The writing implement has a writing tip which preferably is retractable. The writing tip can be retracted by any suitable means. In a preferred embodiment, the tip can be retracted by rotating a first part of the body portion relative to a second part of the body portion.

Any of the embodiments or aspects of the present invention can be used in combination with any of the other embodiments or aspects.

Preferred embodiments of the invention will now be further described with reference to the figures in which:
Figure 1 show a pen according to the present invention;
Figure 2 shows the pen with the flash drive separated from the body of the pen.

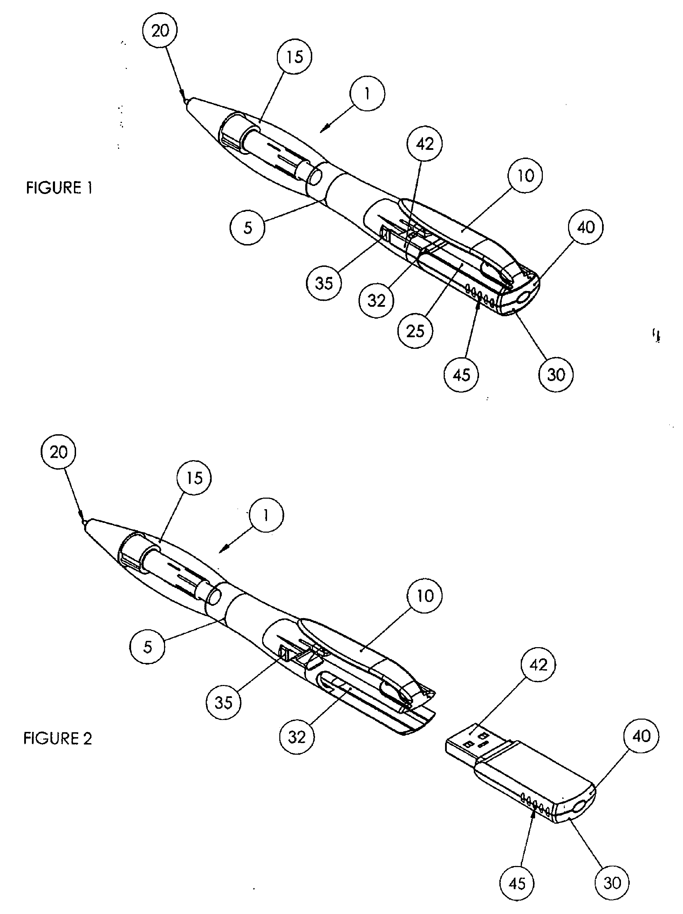

In Figure 1, there is provided a pen 1. The pen 1 comprises a body portion 5, having a pocket clip 10, a grip portion 15, a retractable nib 20 and a receiving portion 25 for receiving a USB flash drive 30.

The receiving portion 25 is formed of a slot 32 at the distal end of the body portion from the nib 20. The slot passes through the whole width of the body portion and is open at both sides. The end of the slot 32 has a permanent neodymium magnet 35.

The USB flash drive 30 has a body portion 40 and a USB interface 42. The body portion 40 is shaped and sized to fit in the slot 32. The body portion has grips 45 on either side, which are exposed when the flash drive 30 is in position in the slot 32. The grips 45 assist with removal and replacement of the flash drive 30 into the slot. The USB interface 42 is held in position by the magnet 35.

Rotation of the grip portion 15 relative to the body portion 5 of the pen either retracts or extends the nib 20 of the pen 1. This is achieved by a conventional retraction mechanism (not shown).

In Figure 2, the flash drive 30 has been separated from the pen 1. The flash drive is formed of a body portion 40 and a USB interface 42.

## Claims

1. A writing implement comprising:
a body portion (5) having a writing tip (20); and
a removable portion comprising a data storage device (30) having a data transfer interface (42),
**characterised in that** the data transfer interface comprises a ferromagnetic material,
wherein the body portion comprises a receiving portion (32) for receiving the data transfer interface, and wherein the receiving portion comprises a magnet (35) such that the magnet releasably connects the receiving portion to the data storage device, wherein the body portion additionally comprises a pocket clip

2. A writing implement as claimed in Claim 1, wherein the writing implement is a pen or a pencil.

3. A writing implement as claimed in any one of the preceding claims, wherein the force required to remove the flash drive is at least 3 N.

4. A writing implement as claimed in any one of the preceding claims, wherein the data transfer interface is a USB interface.

## Patentansprüche

1. Schreibgerät, umfassend:
ein Körperteilstück (5) mit einer Schreibspitze (20), und
ein entfernbares Teilstück, umfassend eine Datenspeichervorrichtung (30) mit einer Datenübertragungsschnittstelle (42), **dadurch gekennzeichnet, dass** die Datenübertragungsschnittstelle ein ferromagnetisches Material umfasst,
wobei das Körperteilstück ein Aufnahmeteilstück (32) zur Aufnahme der Datenübertragungsschnittstelle umfasst, und wobei das Aufnahmeteilstück einen Magneten (35) umfasst, so dass der Magnet das Aufnahmeteilstück trennbar mit der Datenspeichervorrichtung verbindet, wobei das Körperteilstück zusätzlich einen Taschenclip umfasst.

2. Schreibgerät nach Anspruch 1, wobei das Schreibgerät ein Kugelschreiber oder ein Bleistift ist.

3. Schreibgerät nach einem der vorstehenden Ansprüche, wobei die zum Entfernen des Flash-Laufwerks erforderliche Kraft mindestens 3 N beträgt.

4. Schreibgerät nach einem der vorstehenden Ansprüche, wobei die Datenübertragungsschnittstelle eine USB-Schnittstelle ist.

## Revendications

1. Instrument d'écriture comprenant :
une partie corps (5) ayant une pointe d'écriture (20) ; et
une partie amovible comportant un dispositif de stockage de données (30) ayant une interface de transfert de données (42),
**caractérisé en ce que** l'interface de transfert de données comprend un matériau ferromagnétique,
dans lequel la partie corps comprend une partie réceptrice (32) pour recevoir l'interface de transfert de données, et dans lequel la partie réceptrice comprend un aimant (35) de sorte que l'aimant relie de manière amovible la partie réceptrice au dispositif de stockage de données, dans lequel la partie corps comprend en outre une agrafe de poche.

2. Instrument d'écriture selon la revendication 1, dans lequel l'instrument d'écriture est un stylo ou un crayon.

3. Instrument d'écriture selon l'une quelconque des revendications précédentes, dans lequel la force nécessaire pour retirer la clé USB est au moins 3 N.

4. Instrument d'écriture selon l'une quelconque des revendications précédentes, dans lequel l'interface de transfert de données est une interface USB.
